(19) Europäisches Patentamt

**European Patent Office**

**Office européen des brevets**

(11) Veröffentlichungsnummer: **0 236 753 B1**

(12) **EUROPÄISCHE PATENTSCHRIFT**

(45) Veröffentlichungstag der Patentschrift: **22.04.92**

(21) Anmeldenummer: **87101612.7**

(22) Anmeldetag: **06.02.87**

(51) Int. Cl.5: **G01R 1/067**, H01R 11/24

(54) **Prüfklemme.**

(30) Priorität: **08.03.86 DE 3607734**

(43) Veröffentlichungstag der Anmeldung:
**16.09.87 Patentblatt 87/38**

(45) Bekanntmachung des Hinweises auf die
Patenterteilung:
**22.04.92 Patentblatt 92/17**

(84) Benannte Vertragsstaaten:
**AT CH DE ES FR GB LI NL SE**

(56) Entgegenhaltungen:
**DE-U- 8 505 357**
**US-A- 3 864 629**

(73) Patentinhaber: **Richard Hirschmann Electric**
**Oberer Paspelsweg 6-8**
**A-6830 Rankweil-Brederis(AT)**

(72) Erfinder: **Ellensohn, Kurt**
**Zollwehr 12**
**A-6840 Goetzis(AT)**

(74) Vertreter: **Stadler, Heinz, Dipl.-Ing.**
**Richard-Hirschmann-Strasse 19 Postfach 110**
**W-7300 Esslingen a.N.(DE)**

## Beschreibung

Die Erfindung betrifft eine Prüfklemme gemäß dem Oberbegriff des Patentanspruchs 1.

Eine derartige Prüfklemme zum klemmenden Kontaktieren von isolierten Leitungen für Prüfzwecke ist aus der US-A-3,864,629 bekannt. Bei ihr ist die Prüfnadel fest mit dem Handgriff verbunden und innerhalb einer bewegbaren Hülse angeordnet, die einen Klemmenkopf mit axialer Durchführung für die Nadel und einen seitlichen Schlitz zum Einführen der zu kontaktierenden Leitung aufweist. Diese Ausführung eignet sich schon aufgrund des Einführungsschlitzes abhängig von dessen Abmessungen nur für Leitungen mit einem sehr begrenzten Durchmesserbereich. Darüberhinaus ist insbesondere bei dünnen Leitungen, aber auch bei solchen mit einer dicken Isolierung, eine sichere Kontaktierung nicht immer gewährleistet, weil die Leitung oder zumindest die Leitungsader wegen azentrischer Lage an der Nadelspitze vorbeigleiten kann, so daß diese die Isolierung nicht oder nur peripher durchsticht und keine elektrische Verbindung zwischen der leitenden Nadel und der Leitungsader entsteht.

Der Erfindung liegt daher die Aufgabe zugrunde, eine Prüfklemme zu schaffen, die auch bei dünnen Kabeln oder Leitungen mit dicker Isolierung eine sichere elektrische Kontaktierung zwischen der Prüfklemme und damit der mit der Prüfklemme verbundenen Anschlußleitung einerseits und der zu kontaktierenden Leitung bzw. einem zu kontaktierenden Kabel andererseits auch bei kleinen Leitungsquerschnitten sicher gewährleistet.

Diese Aufgabe wird erfindungsgmäß durch die kennzeichnenden Merkmale des Anspruchs 1 gelöst.

Mit Hilfe des Betätigungsteils wird der Klemmenkopf vom festen Klemmenteil weggedrückt, die Prüfklemme öffnet sich dadurch und die zu kontaktierende Leitung kann in die Prüfklemme eingelegt werden. Bei Freigabe des Betätigungsteils schließt sich die Prüfklemme wieder, ohne daß die Nadelspitze zunächst aus ihrer vom bewegbaren Klemmenkopfteil umschlossenen Lage nach außen tritt. Erst wenn die zu kontaktierende Leitung sicher und zentrisch in der U- oder V-förmigen Ausnehmung liegt, wird der bewegbare Klemmenkopfteil entgegen der Federkraft der im Klemmenkopf vorgesehenen Feder nach außen gedrückt und gibt die Nadelspitze frei, so daß sie aufgrund der zentrischen und festen Lage des zu kontaktierenden Kabels zuverlässig in der Mitte durch die Isolierung gedrückt wird und einen sicheren Kontakt mit der Leitungsader bildet. Die Gefahr, daß die zu kontaktierende Leitung von der Kontaktspitze ab- oder an ihr vorbeigleitet, ist daher aufgrund der erfindungsgemäßen Maßnahmen nicht mehr gegeben, da die Leitung zentrisch festgehalten wird, bevor die Nadelspitze in den isolierenden Mantel der Leitung eindringt.

Gemäß einer bevorzugten Ausgestaltung der Erfindung weist das feste Klemmenteil eine zum Klemmenkopf hin offene U-oder V-förmige Ausnehmung auf, in die die zu kontaktierende Leitung bei Freigabe des Betätigungsteils bzw. bei Schließen der Prüfklemme gleitet, so daß auch von der Seite des festen Klemmenteils her die Leitung notwendigerweise in ihre zentrische, ausgerichtete Lage gebracht und in dieser gehalten wird, wodurch die Kontaktierungssicherheit zusätzlich verbessert wird.

Bei der aus der US-A-3,864,629 bekannten Prüfklemme, kann das als Flansch ausgebildete Betätigungsteil aus konstruktiven Gründen nur zwischen Handgriff und Klemmenkopf an der beweglichen Hülse angeordnet sein. Zum Einführen der Leitung müssen somit der Handgriff und der Flansch in Gegenrichtung bewegt werden, was eine umständliche Zweihandbedienung erforderlich macht. Durch eine vorteilhafte Ausgestaltung der Erfindung nach Anspruch 3, ist dagegen eine einfache und zweckmäßigere Handhabung der Prüfspitze mit nur einer Hand ermöglicht, so daß die andere Hand für weitere Tätigkeiten, z.B. dem Festhalten der zu kontaktierenden Leitung, frei bleibt.

Die Erfindung wird nachstehend anhand der Zeichnungen beispielsweise näher erläutert. Es zeigen:

Fig. 1    ein Ausführungsbeispiel der erfindungsgemäßen Prüfklemme, mit einer Querschnittsdarstellung der im Zusammenhang mit der Erfindung relevanten Teile, wobei die Prüfklemme in geöffneter Stellung wiedergegeben ist und

Fig. 2    die Prüfklemme in geschlossener Stellung.

Die dargestellte Prüfklemme weist einen Handgriff 1 mit einer Buchse 2 zum Einstecken eines Kabelsteckers auf. Der Handgriff 1 ist mit einem Rohr 3 fest verbunden, an dessen unterem Ende ein fester Klemmenteil 4 starr befestigt ist. Durch den Handgriff 1 und das Rohr 3 verläuft eine dazu verschiebbare Stange 5, an deren einem Ende ein Druckknopf 6 und an deren anderem Ende ein Klemmenkopf 7 befestigt ist. Am Klemmenkopf 7 ist eine Nadel 8 fest angebracht, die mit ihrer Spitze zum festen Klemmenteil 4 hin weist. Ein kappenförmiges Klemmenkopfteil 9 ist gegenüber der Nadel 8 axial verschiebbar angebracht. Auf der dem festen Klemmenteil 4 zugewandten Seite des Klemmenkopfteils 9 ist eine V-förmige Ausnehmung 12 vorgesehen, die an ihrer tiefsten Stelle eine Durchführungsöffnung aufweist, in der sich in der Ausgangslage die Nadelspitze befindet. Im Klemmenkopfteil 9 befindet sich zwischen einem Querteil 13 des Klemmenkopfes 7 und der Innenseite der klemmseitigen Stirnwand des Klemmenkopfteils 9 eine Klemmenkopffeder 11, die den Klemmenkopfteil 9 in einer Lage hält, in der die Nadel 8 innerhalb des Klemmenkopfteils 9 liegt, d.h. nicht aus der Durchführungsöffnung am tiefsten Punkt der U- oder V-förmigen Ausnehmung 12 herausragt.

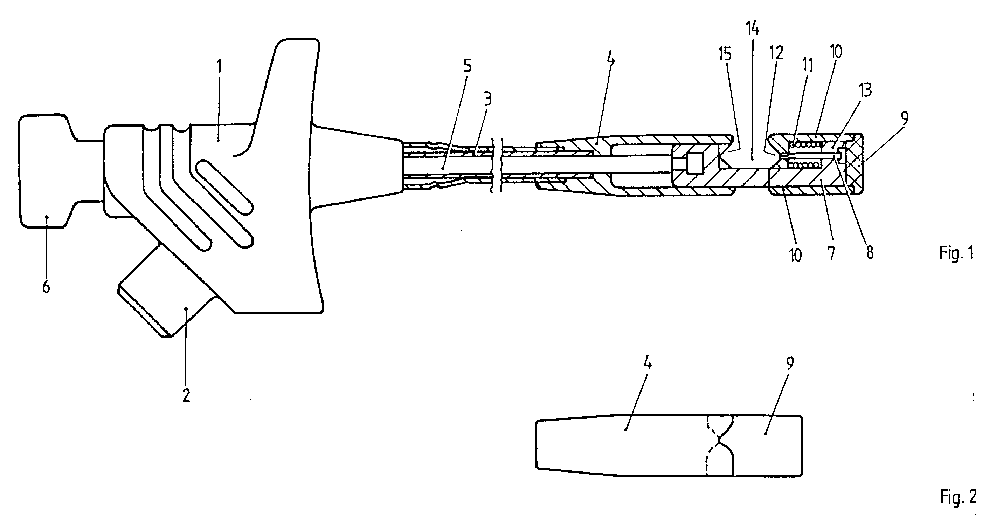

Die erfindungsgemäße Prüfklemme funktioniert folgendermaßen:
Durch Druck auf den Druckknopf 6 (Einhandbedienung) wird die Stange entgegen der Federkraft einer (nicht dargestellten) Feder verschoben, so daß der Klemmenkopf 7 vom festen Klemmenteil 4 weggedrückt wird. Dadurch öffnet sich die Prüfklemme. Diese geöffnete Stellung ist in Fig. 1 dargestellt.

Wird eine zu kontaktierende Leitung in den geöffneten Innenraum 14 eingeführt und der Druckknopf 6 freigegeben, so wird die Stange 5 aufgrund der Federkraft der (nicht dargestellten) Feder zum Handgriff 1 hingezogen, so daß sich der mit der Stange 5 fest verbundene Klemmenkopf 7 zum festen Klemmenteil 4 hin verschiebt. Die zu kontaktierende Leitung wird dabei aufgrund der V-Form der Ausnehmung 12 so ausgerichtet, daß sie darin sicher und fest vor allem aber zentrisch zur Durchführungsöffnung liegt und in dieser Lage gehalten wird.

Wenn die zu kontaktierende Leitung im Innenraum 14 sowohl in der Ausnehmung 12 als auch an der dieser gegenüberliegenden Seite des festen Klemmenteils 4 aufliegt, wird der Klemmerkopf 7 mit der mit diesem starr verbundenen Nadel 8 aufgrund der (nicht dargestellten) Zugfeder weiter zum festen Klemmenteil 4 hingezogen, wobei der gegenüber der Nadel 8 bewegliche Klemmenkopfteil 9 aufgrund des Widerstands durch die zu kontaktierende Leitung unter Zusammendrücken der Klemmenkopffeder 11 im wesentlichen in ihrer Lage bleibt. Dadurch schiebt sich die Nadelspitze durch die Durchführungsöffnung an der tiefsten Stelle der Ausnehmung 12 des Klemmenkopfteils 9 und durchdringt die Isolierung der Leitung, bis sie auf die elektrisch leitende Ader der Leitung stößt und mit ihr in galvanischen Kontakt kommt.

Die (nicht dargestellte) Zugfeder, die sich im wesentlichen innerhalb des Handgriffes 1 befindet und den Klemmenkopf 7 bei freigegebenem Druckknopf 6 zum festen Klemmenteil 4 hinzieht, muß dabei eine stärkere Kraft ausüben, als die Federkraft der Klemmenkopffeder 11, damit der Klemmenkopfteil 9 bezüglich der Nadel 8 verschoben wird, die Nadelspitze 8 frei kommt und durch die Isolierung der Leitung gedrückt werden kann.

Um die Ausrichtung, Zentrierung und Arretierung der zu kontaktierenden Leitung noch weiter zu verbessern, ist auch auf der dem Klemmenkopfteil 9 zugewandten Seite des Klemmenteils 4 eine V-förmige Ausnehmung 15 vorgesehen, wie dies in Fig. 1 dargestellt ist.

Fig. 2 zeigt den Klemmenteil der erfindungsgemäßen Prüfklemme in geschlossenem Zustand, wenn sich keine Leitung in der Klemme befindet.

Der feste Klemmenteil 4 weist dieselbe Lage wie in Fig. 1 auf. Dagegen liegt der Klemmenkopfteil 9 auf dem festen Klemmenteil 4 auf, wobei die gestrichelte Linie die dem festen Klemmenteil zugewandte Seite des Klemmenkopfteils 9 darstellt, d.h., der Klemmenkopfteil 9 liegt auf dem festen Klemmenteil 4 in einer Art Verzahnung derart auf, daß sich die tiefsten Punkte der V-förmigen Ausnehmungen 12 bzw. 15 bei nicht eingelegtem Kabel berühren.

Aufgrund der erfindungsgemäßen Maßnahmen wird die zu kontaktierende Leitung vor dem eigentlichen Kontaktierungsvorgang, d.h. vor dem Eindringen der Nadelspitze in die Isolierung der Leitung, zunächst in die richtige, zentrierte Lage gebracht und in dieser gehalten, so daß die dann die Isolierung durchdringende Nadelspitze sicher auf die leitende Kabelseele trifft, um den Kontakt herzustellen. Ein Ab- oder Vorbeigleiten der Leitung an der Nadelspitze oder ein nur seitliches Durchdringen der Isolierung ohne elektrische Kontaktierung ist dadurch auch bei Leitungen mit kleinsten Querschnitten bis hinab zu 0,1 mm$^2$ sicher vermieden.

## Patentansprüche

1. Prüfklemme mit einem festen Klemmenteil (4) und einem relativ zu diesem federbeaufschlagt bewegbaren Klemmenteil (5,7), das einen Klemmenkopf (7) mit einer Ausnehmung (12) aufweist, in die bei mit Hilfe eines Betätigungsteils (6) gegen Federkraft ausgerücktem Klemmenkopf (7) eine mittels einer elektrisch leitenden Nadel (8) zu kontaktierende Leitung einlegbar ist, **dadurch gekennzeichnet,** daß die Nadel (8) mit ihrer Spitze zum festen Klemmenteil (4) weisend starr mit dem Klemmenkopf (7) verbunden ist, daß der Klemmenkopf (7) einen kappenförmigen Klemmenkopfteil (9,10) aufweist, der gegenüber der Nadel (8) axial verschiebbar ist und diese in seiner Ausgangslage im wesentlichen umschließt, daß die Ausnehmung (12) an der dem festen Klemmenteil (4) zugewandten Stirnseite des Klemmenkopfteils (9,10) angeordnet ist, U- oder V-förmig ausgebildet ist und an ihrem Boden eine zentrale Durchführungsöffnung für die Nadel (8) aufweist, und daß im Klemmenkopf (7) eine Feder (11) vorgesehen ist, gegen deren Federkraft der Klemmenkopfteil (9,10) zur Freigabe der Nadelspitze verschiebbar ist wenn in die Ausnehmung (12) des Klemmenkopfteils (9,10) eine zu kontaktierende Leitung eingelegt und das Betätigungsteil (6) freigegeben ist.

2. Prüfklemme nach Anspruch 1, dadurch gekennzeichnet, daß das feste Klemmenteil (4) eine zum Klemmenkopf (7) hin offene U- oder V-förmige Ausnehmung (15) aufweist.

3. Prüfklemme nach Anspruch 1 oder 2, dadurch gekennzeichnet, daß das bewegbare Klemmenteil (5,7) innerhalb des festen Klemmenteils (4) angeordnet ist und das Betätigungsteil (6) ein mit dem handgriffseitigen Ende des bewegbaren Klemmenteils (5,7) verbundener, gegen den Handgriff (1) drückbarer Druckknopf ist.

## Claims

1. Test terminal with a fixed terminal component (4) and a terminal component (5, 7), which has springloaded mobility relative to this, which has a terminal head (7) with a recess (12), into which a lead, connectable by means of an electrically conducting needle (8), is insertable in the case of the terminal head (7) being disconnected against spring resistance by means of an actuation element (6),

   **in such a way characterized,** that the needle (8), with its tip pointing to the fixed terminal component (4), is rigidly connected with the terminal head (7), that the terminal head (7) has a dome-shaped terminal head component (9, 10), which is axially movable in relation to the needle (8) and essentially encloses this in its original position, that the recess (12) is arranged on the front-side of the terminal head components (9, 10) facing the fixed terminal component (4), formed in a U- or V-shape and has a central lead-in opening in its base for the needle (8), and that a spring (11) is provided in the terminal head (7), against the spring resistance of which the terminal head component (9, 10) is movable for the purpose of releasing the needle tip, if a lead, which is to be connected, is inserted in the recess (12) of the terminal head component (9, 10) and the actuation element (6) is released.

2. Test terminal according to claim 1, **in such a way characterized,** that the fixed terminal component (4) has an open U- or V-shaped recess (15) facing the terminal head (7).

3. Test terminal according to claim 1 or 2, **in such a way characterized,** that the movable terminal component (5, 7) is arranged inside the fixed terminal component (4) and the actuation element (6) is a push button, which is joined with the end of the movable terminal component (5, 7) adjacent to the handle (1) and which can be pushed against the handle (1).

## Revendications

1. Une borne d'essai munie d'un élément fixe (4) et d'un élément à ressort, mobile relatif au premier (5, 7), qui dispose d'une tête de borne (7) avec un creux (12), dans lequel, la tête de borne (7) ouverte contre l'effet de ressort, peut être introduit un câble moyennant un dispositif de commande (6), câble qui est à contacter par une aiguille conductrice (8),

   **caractérisée par les faits** que l'aiguille (8), dont la pointe montre sur l'élément fixe de la borne (4), est fermement jointe à la tête de borne (7), que la tête de borne (7) comprend une partie en forme de chapeau (9, 10) décalable sur l'axe de l'aiguille (8) qui en sa position originelle enferme presque l'aiguille entière, que le creux (12) se trouve sur la face de la tête de borne (9, 10) montrant vers l'élément fixe de la borne (4), ayant la forme d'un U ou d'un V et disposant sur son fond d'une percée de passage pour l'aiguille (8) et qu'un ressort (11) est prévu dans la tête de borne (7) contre l'effet duquel la partie de la tête de borne (9, 10) est décalable pour libérer la pointe de l'aiguille quand un câble à contacter est introduit dans le creux (12) de la partie de la tête de borne (9, 10) et le dispositif de commande (6) est débloqué.

2. Une borne d'essai comme en demande 1, **caractérisée par** l'élément fixe (4) qui présente un creux (15) en forme d'un U ou d'un V ouvert vers la tête de borne (7).

3. Une borne d'essai comme en demande 1 ou 2, **caractérisée par les faits** que l'élément mobile (5, 7) est situé à l'intérieur de l'élément fixe (4) et que le dispositif de commande (6) est un bouton-poussoir lié au bout du côté-levier de l'élément mobile de la borne (5, 7) et qu'on pousse vers le levier (1).

Fig. 1

Fig. 2